(19) **Europäisches Patentamt**

**European Patent Office**

**Office européen des brevets**

(11) **EP 0 469 401 B1**

(12) **EUROPEAN PATENT SPECIFICATION**

(45) Date of publication and mention
of the grant of the patent:
**02.11.2000 Bulletin 2000/44**

(51) Int. Cl.[7]: **H01L 21/311**

(21) Application number: **91112056.6**

(22) Date of filing: **18.07.1991**

(54) **Method of producing a semiconductor device by dry etching two superposed SiO2 layers**

Verfahren zum Herstellen eines Halbleiterbauelementes durch Trockenätzung zweier aufgestapelten SiO2-Schichten

Méthode de fabrication d'un composant semi-conducteur par gravure sèche de deux couches superposées de SiO2

(84) Designated Contracting States:
**GB**

(30) Priority: **30.07.1990 JP 20181190**
**05.04.1991 JP 7281191**

(43) Date of publication of application:
**05.02.1992 Bulletin 1992/06**

(73) Proprietor:
**SEIKO EPSON CORPORATION**
**Shinjuku-ku Tokyo-to (JP)**

(72) Inventor: **Namose, Isamu**
**Suwa-shi, Nagano-ken (JP)**

(74) Representative:
**Hoffmann, Eckart, Dipl.-Ing.**
**Patentanwalt,**
**Bahnhofstrasse 103**
**82166 Gräfelfing (DE)**

(56) References cited:
**EP-A- 0 243 273**         **EP-A- 0 249 173**
**EP-A- 0 284 124**         **EP-A- 0 368 504**
**EP-A- 0 386 337**

- **IBM TECHNICAL DISCLOSURE BULLETIN. vol. 32, no. 8B, January 1990, NEW YORK US pages 31 - 32; "Improved planarization, Silicon dioxide insulation and adjustable insulation etch rate by using siloxane"**
- **PROCEEDS. OF THE 3RD. INT. IEEE VLSI MULTILEVEL INTERCONNECTION CONFERENCE 09 June 1986, SANTA CLARA, CA. pages 100 - 106; Pat ELKINS et al.: "A planarization process for double metal CMOS using spin-on- glass as a sacrificial layer"**
- **PATENT ABSTRACTS OF JAPAN vol. 5, no. 109 (E-65)(781) 15 July 1981, & JP-A-56 048140 (SUWA SEIKOSHA K.K.) 01 May 1981,**
- **JOURNAL OF APPLIED PHYSICS. vol. 63, no. 7, 01 April 1988, NEW YORK US pages 2463 - 2466; T.R. VERHEY et al.: "Anisotropic plasma-chemical etching by an electron-beam-generated plasma"**

## Description

The present invention relates to a method of producing a semiconductor device, and more particularly to a reactive ion etching technique suitable for example for achieving a flat silicon oxide layer.

In the multilayer interconnecting structure of a semiconductor device, if aluminum is vapor-deposited onto a stepped portion having a steep and complicated ruggedness, failures such as a broken line or an interlayer insulation failure may be caused in the aluminum wiring layer. Thus it is necessary to consider a method for forming a layer by which the surface of a wafer having steps in it is smoothly flattened.

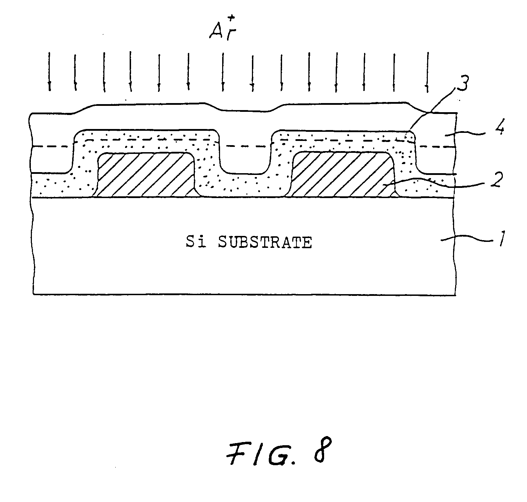

Fig. 8 is a sectional view of a semiconductor device illustrating an example of a conventional method for flattening a silicon oxide layer in a semiconductor device.

In this figure, numeral 2 denotes an aluminum wiring formed by vapor deposition on an Si-substrate 1. An etchback method is employed for flattening a silicon oxide layer on this aluminum wiring. That is an SOG (spin-on-glass) layer 4 is applied on an $SiO_2$ layer 3 formed by a CVD method or thermal oxidation, and the $SiO_2$ layer 3 is subjected to dry etching together with the SOG layer 4 to achieve a flatness thereof by cutting off the surface to the broken line as shown in the figure. Such dry etching is rendered by sputter etching or ion milling using an inert Ar gas. The selection ratio of the SOG layer 4 (second silicon oxide layer) with respect to the foundation $SiO_2$ layer 3 (first silicon oxide layer) is about 1.18. The selection ratio is the ratio of the etching rate for different types of silicon oxide layers.

Although a small selection ratio (1.18) may be obtained by sputter etching or ion milling using Ar gas in a simultaneous etching process for different types of silicon oxide layer such as the flattening process, there are the following problems:

(1) Since these methods are physical etching methods in which relatively heavy inert Ar ions are caused to impact on the SOG layer 4 and $SiO_2$ layer 3 to strip molecules from the surface, the etching rate is low and usually is several tens nm/min. Thus a long time is required for the etching process. Accordingly, while the preciseness in flattening is improved with a thicker SOG layer 4, the thicker the SOG layer 4 formed to increase the preciseness in flattening, the longer the time required for etching.

(2) Also, because they are physical etching methods, a damage resulting from the impact is caused at the same time, adversely affecting the characteristic (for example threshold voltage) of transistors formed on the substrate. On the other hand, the removed $SiO_2$ molecules adhere such as to the opposite electrode, and the separation of such readhering layer causes an occurrence of remaining particles, resulting in a lower yield. This problem is more apparent as the SOG layer 4 becomes thicker.

A method for flattening superposed oxide layers is known from EP-A-284124, as well as from EP-A-249173.

Thus the present invention has been made to eliminate the above described problems, and its object is to provide a method of producing a semiconductor device in which a reduction in etching time and an improved yield with high reliability may be achieved by employing a dry etching method with a high etching rate while keeping the selection ratio low in the process for simultaneously etching a first silicon oxide layer and a different second silicon oxide layer.

This object is achieved with a method as claimed in claim 1.

Specific embodiments of the invention will be explained in detail below with reference to the drawings, in which:

Fig. 1 is a sectional view corresponding to Example 1 where the present invention is applied to the flattening process of silicon oxide layers,

Fig. 2 is a graph showing the relationship between the etching rate and the selection ratio, respectively, and the mixing ratio of hexafluoroethane gas ($C_2F_6$) and Ar gas in a reactive ion etching according to Example 1 of the present invention.

Fig. 3 is a graph for evaluating the etching rate and uniformity with respect to a thermal oxidation layer $SiO_2$ by varying RF power in a reactive ion etching according to Example 1 of the present invention.

Fig. 4 is a graph showing the relationship between the etching rate and selection ratio, respectively, and the mixing ratio of tetrafluoromethane gas ($C_1F_4$) and Ar gas in a reactive ion etching according to Example 2 of the present invention.

Fig. 5 is a graph showing the relationship between the etching rate and selection ratio, respectively, and the mixing ratio of octafluoropropane gas ($C_3F_8$) and Ar gas in a reactive ion etching according to Example 2 of the present invention.

Fig. 6 is a graph showing the relationship between the etching rate and selection ratio, respectively, and the mixing ratio of hexafluoroethane gas ($C_2F_6$) and He gas in a reactive ion etching according to another example of the present invention.

Fig. 7    is a graph showing the relationship between the etching rate and selection ratio, respectively, and the mixing ratio of hexafluoroethane gas ($C_2F_6$) and Xe gas in a reactive ion etching according to another example of the present invention.

Fig. 8    is a sectional view illustrating an example of a conventional flattening method of a silicon oxide layer in a semiconductor device.

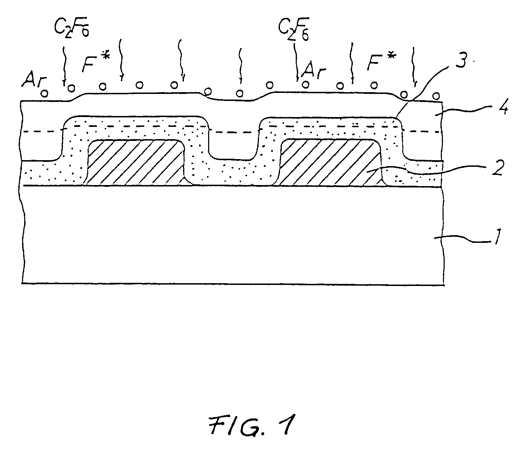

As shown in Fig. 1, in the production process for a semiconductor device, an $SiO_2$ layer 3 serving as a first silicon oxide layer is formed by a CVD method or thermal oxidation on the aluminum wiring 2 which has been formed by vapor deposition on an Si-substrate 1, and an SOG (spin-on-glass) layer 4 is applied by a spinner as a second silicon oxide layer onto the $SiO_2$ layer 3 having a ruggedness reflecting the steps in the aluminum wiring 2. And, while a reactive ion etching is employed as the dry etching in an etchback process, a mixed gas consisting of a carbon fluoride gas such as $C_2F_6$ and an inert gas such as He, Ar, Xe is used.

Since in principle a carbon fluoride gas ($CnF2n+_2$) is used, a fluorine radical $F^*$ is generated so that an etching is proceeded by causing the following reaction with the silicon oxide layers.

$$SiO_2 + 4F^* \rightarrow SiF_4 \uparrow + 0_2 \uparrow \qquad (1)$$

Because this is a chemical etching, while a high etching rate is achieved, a low value close to 1 is obtained as the ratio of etching rates (selection ratio) for different types of silicon oxide layers. Although its mechanism has not been brought to light, it is presumed that inert gas atoms are caused to adhere to the etching surface to control the rate of chemical etching. Since a physical impact to the interior of the silicon oxide layer or to the semiconductor active region does not occur due to the fact that this is a chemical etching by fluorine radical $F^*$ acting like a shock absorber upon the silicon oxide layer surface, it is possible to prevent for example a degradation in transistor characteristics caused by the etching process itself. Furthermore, since $SiF_4$, the resulting matter of the reaction, is volatile, remaining $SiO_2$ particles do not occur, and the etched surface remains at all times as a clean silicon oxide layer. Thus the yield in etching process is improved.

EXAMPLE 1

First the case was investigated where an argon gas was added in a reactive ion etching using hexafluoroethane gas ($C_2F_6$).

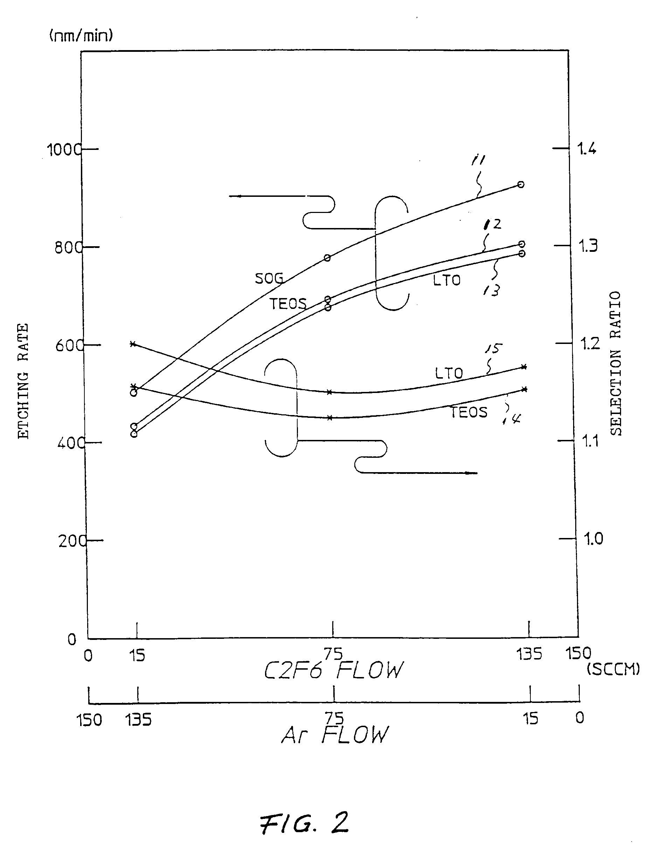

Fig. 2 is a graph showing the relationship between the etching rate and selection ratio for various types of silicon oxide layers versus the mixing ratio of hexafluoroethane gas ($C_2F_6$) and Ar gas. While in reality various types of silicon oxide layers are obtainable, a reactive ion etching in this example was effected by taking an SOG layer, a TEOS (tetra-ethoxy-ortho-silicate) layer, and an LTO (low temperature thermal oxidation $SiO_2$) layer as the representative examples. Under the conditions of a 27 Pa (200 mTorr) gas pressure, a RF power of 800 W, ten seconds of etching time and a total flow per unit amount of 150 sccm, the mixing ratio (flow ratio) of hexafluoroethane gas ($C_2F_6$) and Ar gas was varied to obtain the data on the etching rate (the left side vertical axis) for each of the above described layers (shown by solid lines 11, 12, 13). It is presumed that the characteristic curve group of the etching rate for the other various silicon oxide layers is generally interposed between the curve for an SOG layer and the curve for a TEOS layer as shown in Fig.2. Referring to Fig. 2, though the etching rate became lower with an increase in the Ar gas proportion, the etching rate was in general several hundreds nm/min (400~1000 nm/min). This is more than ten times greater than the etching rate in a conventional sputter etching or ion milling using AR gas.

In Fig. 2, selection ratios on the basis of the SOG layer are also shown by solid lines 14, 15 (the right side vertical axis). The selection ratio for the TEOS layer and the selection ratio for the LTO layer were generally close to each other and they fell within the range of 1.12 ~ 1.17. When the mixing ratio was 50%, both of the selection ratios were about 1.12. Such selection ratio value is a value suitable for such in a flattening process and is by no means inferior to the selection ratio (1.18) according to a conventional sputtering or ion milling using Ar gas.

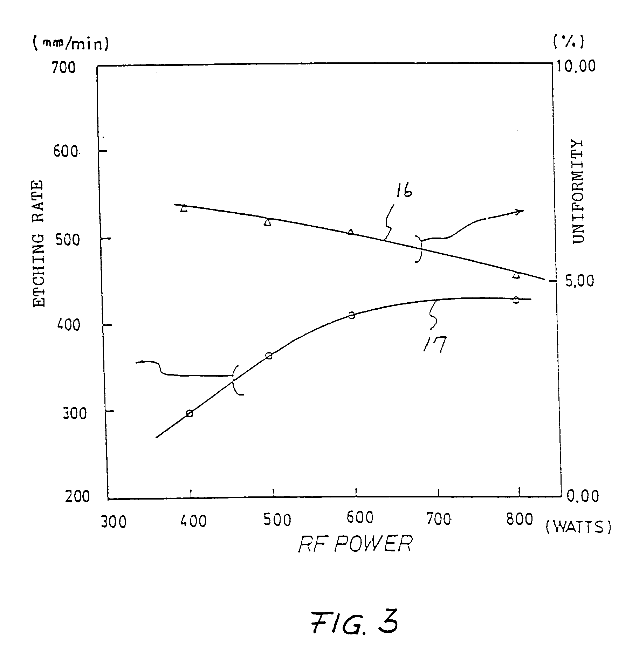

Next as shown in the graph of Fig. 3 by varying the RF power the etching rate (left side vertical axis) and uniformity (right side vertical axis) for an $SiO_2$ layer formed by thermal oxidation were evaluated. The conditions were: 27 PA (200 mTorr) gas pressure, 17 seconds of etching time, 15 sccm of hexafluoroethane gas ($C_2F_6$) and 135 sccm of Ar gas. As shown by a solid line 17 in Fig.3, the etching rate became higher with an increase in the RF power. On the other hand, the uniformity on the etched surface decreased gradually as shown by a solid line 16.

Next as shown in Fig. 1 an $SiO_2$ layer 3 of 600 nm thickness was formed by thermal oxidation on an aluminum wiring 2 formed by vapor deposition on the Si-substrate 1, an SOG layer of 70 nm thickness was applied onto this $SiO_2$ layer 3 by a spinner, and thereafter an etchback was effected for about 18 seconds by reactive ion etching (RF power of 800W) using a mixed gas consisting of hexafluoroethane gas ($C_2F_6$ : 15 sccm) and Ar gas (135 sccm). As a result, the etchback was 150 nm, substantial selection ratio was about 1.1, the etching time in the flattening process was reduced by about 10% compared to the conventional method. Also, since it is a non-impacting chemical etching, such as an adverse effect on the layer quality and the degradation in transistor characteristics may be avoided. Further, since the product of reaction is volatile, a contamination or the like by the remaining particles does not occur, the yield being improved in comparison with the conventional methods.

EXAMPLE 2

In this case argon gas was added in a reactive ion etching using a tetrafluoromethane gas ($CF_4$) and an octafluoropropane gas ($C_3F_8$).

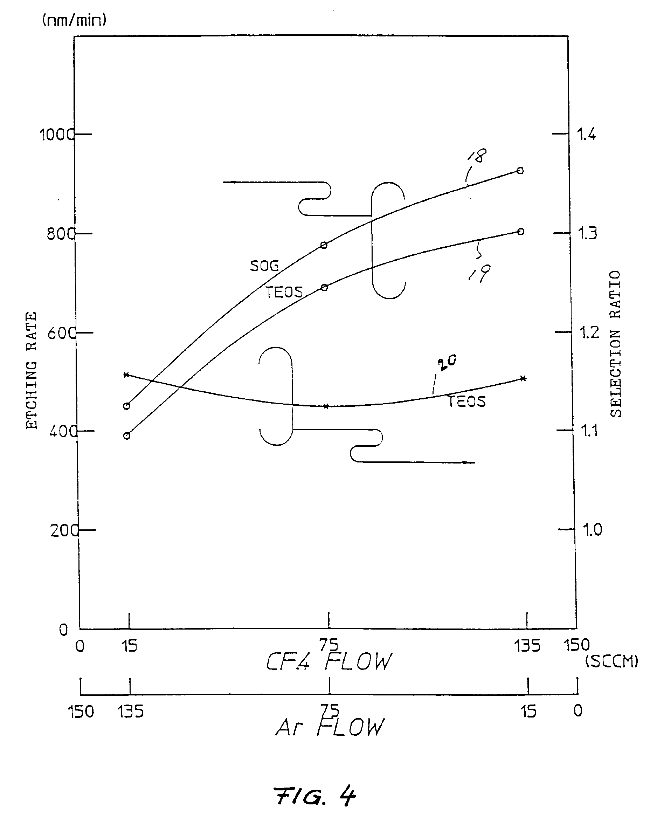

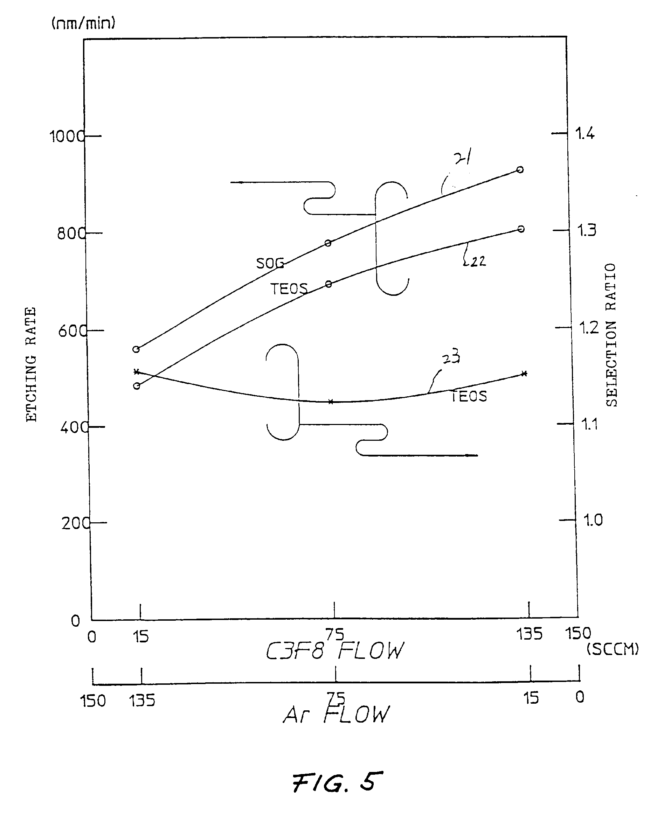

Fig. 4 is a graph showing the relationship between the etching rate and selection ratio on the silicon oxide layer versus the mixing ratio between tetrafluoromethane gas ($CF_4$) and Ar gas, and Fig. 5 is a graph showing the relationship between the etching rate and selection ratio on the silicon oxide layer versus the mixing ratio between octafluoropropane gas ($C_3F_8$) and Ar gas. The silicon oxide layers treated with reactive ion etching were an SOG layer and a TEOS layer. Further, the conditions were similar to Example 1, that is, the data on the etching rate (left side vertical axis) and the selection ratio on the basis of an SOG layer (right side vertical axis) were obtained by varying the mixing ratio (flow ratio) of tetrafluoromethane gas ($CF_4$), octafluoropropane gas ($C_3F_8$) and Ar gas under the condition of a gas pressure of 27 Pa (200 mTorr), an RF power of 800 W, an etching time of 10 seconds and a total flow amount of 150 sccm per unit.

Referring to Fig. 4, in the case where a mixed gas consisting of tetrafluoromethane gas ($CF_4$) and Ar gas was used, the etching rate on each layer was several hundreds nm/min (400~1000 nm/min) as shown in solid lines 18, 19, though it became lower with an increase in the proportion of Ar gas. Also, as shown by solid line 20, the selection ratio on the basis of an TEOS layer was within the range of 1.12~1.16 and the selection ratio with a 50% mixing ratio was about 1.12.

On the other hand, referring to Fig. 5, in the case where a mixed gas consisting of octafluoropropane gas ($C_3F_8$) and Ar gas was used, the etching rate on each layer was also several hundreds nm/min (400~1000 nm/min as shown by solid lines 21, 22, though it became lower with an increase in the proportion of Ar gas. Further, as shown by solid line 23, the selection ratio on the basis of an TEOS layer was within the range of 1.12~1.16 and the selection ratio with a 50% mixing ratio was about 1.12.

Thus, in both of the cases of Example 2, the etching rate was at the same level as in the case of using a mixed gas consisting of *hexafluoroethane* gas ($C_2F_6$) and Ar gas, the etching rate being more than ten times greater than the etching rate of a conventional sputter etching or ion milling using Ar gas. Further, the value of the selection ratio was at the same level as the selection ratio in the case of using a mixed gas consisting of *hexafluoroethane* gas ($C_2F_6$) and Ar gas and was by no means inferior to the selection ratio (1.18) obtained by the conventional sputtering or ion milling using Ar gas.

Accordingly, when this method is applied to the flattening process for a multilayer interconnection in a similar manner as Example 1, the etching time for the flattening process is also reduced compared to the conventional method and the yield is improved.

OTHER EXAMPLES

Furthermore, investigations were conducted similar to Example 2 with respect to reactive ion etchings respectively using a mixed gas consisting of hexafluoroethane gas ($C_2F_6$) and helium gas and a mixed gas consisting of hexafluoroethane gas ($C_2F_6$) and xenon gas. Here, the types of silicon oxide layers to be treated by reactive ion etching and the conditions of the reactive ion etching were the same as in Example 2.

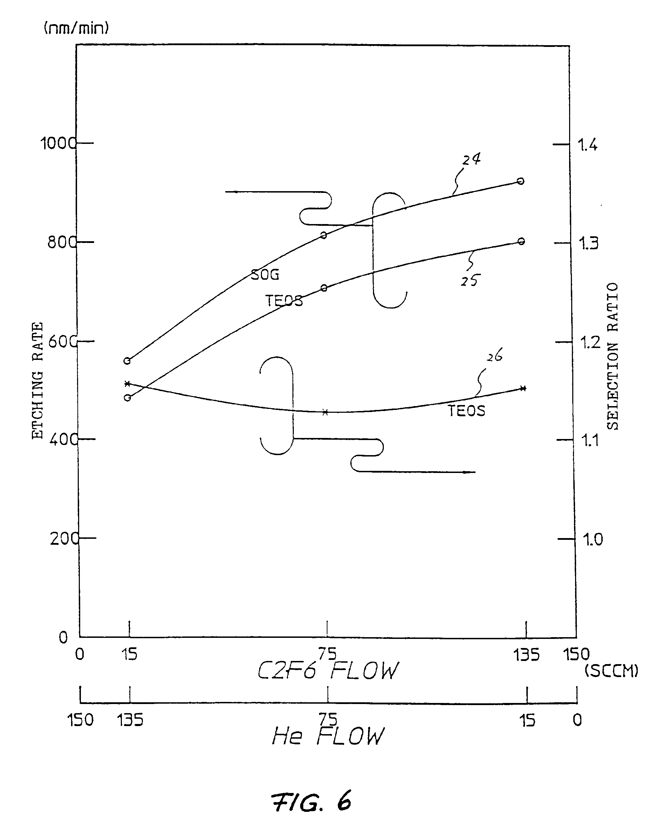

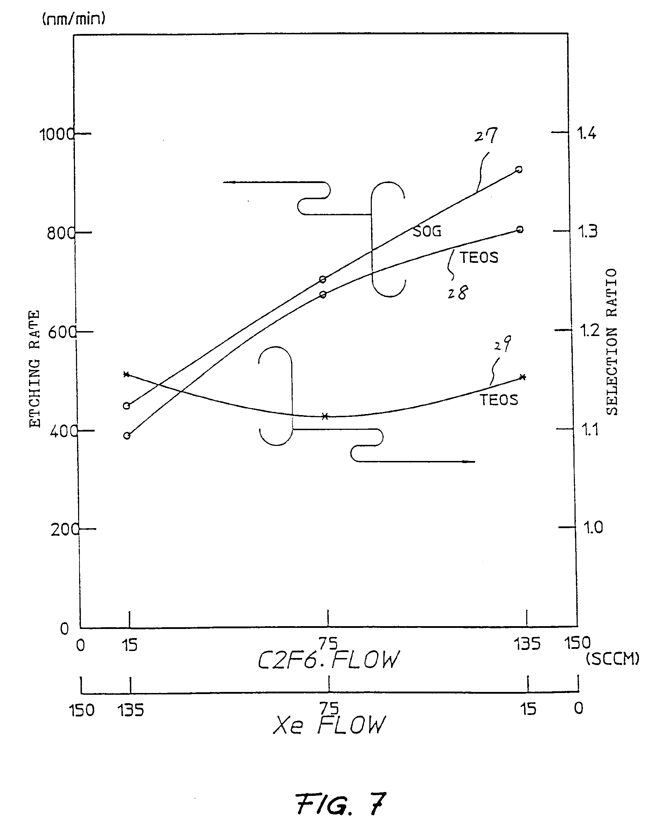

Fig. 6 is a graph showing the relationship between the etching rate (left side vertical axis) and selection ratio (right side vertical axis) versus the mixing ratio of hexafluoroethane gas ($C_2F_6$) and He gas, and Fig. 7 is a graph showing the relationship between the etching rate (left side vertical axis) and selection ratio (right side vertical axis) versus the mixing ratio of hexafluoroethane gas ($C_2F_6$) and Xe gas.

Referring to Fig. 6, when a mixed gas consisting of hexafluoroethane gas ($C_2F_6$) and He gas was used, the etching rate was also several hundreds nm/min (400~1000 nm/min) as shown by solid lines 24, 25, though it became lower with an increase in the proportion of He gas. Further, as shown by solid line 26, the selection ratio on the basis of an TEOS layer was within the range of 1.12~1.16 and the selection ratio with a 50% mixing ratio was about 1.12.

On the other hand, referring to Fig. 7, when a mixed gas consisting of hexafluoroethane gas ($C_2F_6$) and Xe gas was used, the etching rate on each layer was also several hundreds nm/min (400~1000 nm/min) as shown by solid lines 27, 28 though it became lower with an increase in the proportion of Xe gas. Further, as shown by a solid line 29, the selection ratio on the basis of an TEOS layer was within the range of 1.12~1.16 and the selection ratio with a 50% mixing ratio was about 1.12.

Thus, an etching rate more than ten times greater than that of the conventional sputter etching and ion milling using Ar gas was obtained, while the selection ratio was not inferior, for both cases, a mixed gas consisting of hexafluoroethane gas ($C_2F_6$) and He gas and a mixed gas consisting of hexafluoroethane gas ($C_2F_6$) and Xe gas.

Accordingly, when these methods are applied to the flattening process in a multilayer interconnection in a similar manner as Example 1, the etching time for a flattening process is also reduced compared to the conventional method and the yield is improved.

As has been described, while, in any of the examples, the etching time in flattening process is reduced compared to the conventional method and the yield is improved, it is presumable that a similar effect may be obtained even when still other types of silicon oxide layers are used or even when an evaluation is made for various fluoride gases and inert gases by changing their types and combinations.

It should be noted that the above described reactive ion etching may be applied not only to the flattening process in a multilayer interconnection but also to a co-etching process such as the groove-filling process of a trench which will be effected on two or more types of silicon oxide layers with a low selection ratio.

As has been described above, on the basis of reactive ion etching by a fluorine radical F*, the present invention achieves the following advantages:

(1) Since the etching rate is more than ten times greater than that of the physical etching method in a conventional sputter etching or ion milling, the etching process may be completed in a shorter time period. In addition, a low selection ratio substantially similar to those in the above described conventional etching methods is provided as the selection ratio with respect to different silicon oxide layers. Thus, when applied for example to a flattening process of silicon oxide layers, it is possible to shorten the time for an etchback process. On the other hand, even when the layer thickness of a second silicon oxide layer to be attached to the silicon oxide layer forming the foundation is made relatively thicker than according to the conventional practice so as to improve the precision in flattening, it is possible to shorten the etchback processing time.

(2) Since it is a chemical etching, the problems of an etching process such as degradation of layer quality and adverse effect on transistor characteristics may be avoided.

(3) Since the product of reaction is volatile, readhering of the remaining particles to the wafer surface does not occur and an improvement in yield may be achieved.

## Claims

1. A method of planarizing a semiconductor substrate having a rugged first silicon oxide layer of either tetra-ethoxy-ortho-silicate or low temperature thermal oxidation $SiO_2$ formed thereon, the method comprising the steps of

a) forming as a second silicon oxide layer an SOG layer on said first silicon oxide layer,
b) providing an etching gas mixture at a total flow per unit amount of 150 sccm, the gas mixture consisting of only a carbon fluoride gas, $C_nF_{2n+2}$, wherein n is an integer, and an inert gas at a flow ratio of 15:135 to 135:15,

c) creating a plasma at a gas pressure of 27 Pa and an RF power of 800 W, wherein fluorine radicals are liberated in the plasma, and
d) applying the fluorine radicals to an etching surface of said substrate resulting from step a) so as to dry-etch said first and second layers in a single etch step.

2. The method of claim 1 wherein said inert gas comprises one gas or a mixture of two or more gases selected from He, Ar, Xe.

## Patentansprüche

1. Verfahren zum Nivellieren eines Halbleitersubstrats mit einer darauf ausgebildeten unebenen ersten Siliciumoxidschicht aus entweder Tetra-Ethoxy-Orthosilikat oder durch thermische Oxidation bei niedriger Temperatur ausgebildetem $SiO_2$, umfassend die Schritte

a) Bilden einer SOG-Schicht auf der ersten Siliciumoxidschicht als zweite Siliciumoxidschicht,
b) Liefern einer Ätzgasmischung mit einer Gesamtströmung pro Mengeneinheit von 150 sccm, wobei die Gasmischung lediglich aus einem Kohlenstofffluoridgas, $C_nF_{2n+2}$, wobei n eine ganze Zahl ist, und einem inerten Gas in einem Strömungsverhältnis von 15:135 bis 135:15 besteht,
c) Schaffen eines Plasmas bei einem Gasdruck von 27 Pa und einer Hochfrequenzleistung von 800 W, wobei Fluorradikale in dem Plasma freigesetzt werden, und
d) Zuführen der Fluorradikale zu einer Ätzoberfläche des Substrats, das aus Schritt a) resultiert, um die erste und die zweite Schicht in einem einzigen Ätzschritt trockenzuätzen.

2. Verfahren nach Anspruch 1, bei dem das inerte Gas ein Gas oder eine Mischung aus zwei oder mehr Gasen ausgewählt aus He, Ar, Xe umfaßt.

## Revendications

1. Procédé pour aplanir un substrat de semi-conducteur ayant une première couche irrégulière d'oxyde de silicium soit de tétra-éthoxy-ortho-silicate soit de SiO2 d'oxydation thermique à basse température formée sur celui-ci, le procédé comprenant les étapes consistant à

a) former comme deuxième couche d'oxyde de silicium une couche de verre déposée à la tournette sur ladite première couche d'oxyde de silicium,
b) alimenter un mélange de gaz de gravure à un débit total par quantité unitaire de 150 sccm, le mélange de gaz se composant seulement d'un fluorure de carbone gazeux, $C_nF_{2n+2}$, où n est un nombre entier, et d'un gaz inerte à un rapport de débit de 15:135 à 135:15,

c) créer un plasma à une pression de gaz de 27 Pa et à une puissance RF de 800 W, des radicaux de fluor étant ainsi libérés dans le plasma, et

d) appliquer les radicaux de fluor à une surface de gravure dudit substrat résultant de l'étape a) de façon à graver à sec lesdites première et deuxième couches en une seule opération de gravure.

2. Procédé selon la revendication 1 dans lequel ledit gaz inerte comprend un gaz ou un mélange de deux gaz ou plus choisis parmi He, Ar, Xe.

FIG. 1

FIG. 2

FIG. 3

FIG. 4

FIG. 5

FIG. 6

*FIG. 7*

$Ar^+$

3

4

2

Si SUBSTRATE

1

FIG. 8